# EUROPÄISCHE PATENTSCHRIFT

(11) **EP 1 891 425 B1**
(45) Veröffentlichungstag und Bekanntmachung des Hinweises auf die Patenterteilung: **05.10.2011**
(21) Anmeldenummer: 06754196.1
(22) Anmeldetag: 08.06.2006
(51) Int. Cl.: G01N 27/414

(54) **SENSOR MIT OBERFLÄCHENBEHANDELTEN ALUMINIUMTEILEN UND VERFAHREN ZU DESSEN HERSTELLUNG**
SENSOR COMPRISING SURFACE-TREATED ALUMINIUM PARTS AND METHOD FOR THE PRODUCTION THEREOF
CAPTEUR COMPORTANT DES PIECES EN ALUMINIUM AYANT SUBI UN TRAITEMENT DE SURFACE, ET SON PROCEDE DE PRODUCTION

(30) Priorität: 10.06.2005 DE 102005026981
(43) Veröffentlichungstag der Anmeldung: 27.02.2008
(73) Patentinhaber: Micronas GmbH, 79108 Freiburg i. Br. (DE)
(72) Erfinder: KNITTEL, Thorsten, Dr., 93049 Regensburg (DE); FREITAG, Gunter, 81735 München (DE); EISELE, Ignaz, 82057 Icking (DE)
(74) Vertreter: Göhring, Robert
(86) Internationale Anmeldenummer: PCT/EP2006/005441
(87) Internationale Veröffentlichungsnummer: WO 2006/131341

(56) Entgegenhaltungen:
- US-A- 4 238 757
- US-A- 4 490 216
- US-A- 5 693 545
- US-A1- 2003 017 508
- ANGST D L ET AL: "Moisture Absorption Characteristics of Organosiloxane Self-Assembled Monolayers" LANGMUIR, AMERICAN CHEMICAL SOCIETY, NEW YORK, NY, US, Bd. 7, Nr. 10, 1991, Seiten 2236-2242, XP002331481 ISSN: 0743-7463

## Beschreibung

Die Erfindung betrifft einen Sensor mit Aluminium-Teilen, und ein Verfahren zu dessen Herstellung. Ein solcher Sensor ist z.B. aus US4238757 bekannt.

Die in der Luft enthaltene Feuchtigkeit bildet an Oberflächen, insbesondere an metallischen Oberflächen, bei variierenden Betriebsbedingungen dünne Wasserfilme, die zu erhöhter Oberflächenleitfähigkeit führen. Bei Sensoren entstehen Probleme insbesondere an Teilen, die entweder aus Silizium, siliziumhaltigem Material oder Aluminium oder aluminiumhaltigem Material bestehen. Die genannten oberflächlichen Wasserfilme führen zu erhöhten Leckströmen und stellen somit an Sensoren, deren Nutzsignale elektrische Signale sind, wesentliche Störgrößen dar. Derartige Sensoren stehen meist zur Detektion bestimmter physikalischer Größen mit Luft in Kontakt. Somit können unterschiedliche Sensoreigenschaften, beispielsweise bezüglich der Stabilität und des allgemeinen Signalverhaltens eines Sensors, wesentlich beeinflusst werden.

Um nachteilige Feuchteeinflüsse auf Sensoren oder Sensorsysteme zu vermeiden, können diese beispielsweise gekapselt aufgebaut werden. Eine Methode in Verbindung mit Gassensoren besteht darin, passive Membranen zum Ausschluss von ungewünschten Störgasen einzusetzen. Werden durch den Sensor beispielsweise aggressive Zielgase detektiert, so muss jedoch mit einer verkürzten Lebensdauer des Sensors gerechnet werden.

Die Beheizung von Gassensoren beispielsweise über 100° C stellt eine Teillösung dar, ist jedoch mit erheblichem Energieaufwand verbunden.

Bei Sensoren, die Halbleiterbauteile als wesentliche Bestandteile aufweisen, sind oft Metallisierungen aus Aluminium vorhanden. Aluminium kann leicht von Säuren angegriffen werden. Die Gassensoren, die regelmäßig mit Umgebungsatmosphäre in Verbindung stehen, sind somit verstärkter Korrosion ausgesetzt. Dabei werden in der Atmosphäre enthaltene Säuren mit einem Feuchtigkeitsniederschlag auf der Metallisierung abgelagert. Um dies auszuschließen kann die Metallisierung durch herkömmliches Vergießen beispielsweise in Kunststoff geschützt werden. CMOS-Bauteile werden derart gegen Korrosion geschützt. Ein Korrosionsschutz bei Gassensoren, die aggressive Gase detektieren, muss anderen Anforderungen genügen. Da ein Gassensor zwangsläufig mit dem Messgas zur Detektion eines darin vorhandenen Zielgases in Kontakt kommen muss, ist zu erwarten, dass seine Lebensdauer sehr gering ist.

Aus der nach veröffentlichten deutschen Patentanmeldung mit dem amtlichen Anmeldekennzeichen 102004035551 sind ein Sensor und ein Verfahren zu dessen Herstellung bekannt, wobei siliziumhaltige Bauteile in Sensoren dadurch vor Feuchtigkeit geschützt werden, dass sie mit einer Schicht aus hydrophobem Material belegt sind. Zur Herstellung dieser Schicht wird das Verfahren der Silanisierung eingesetzt. Dabei entsteht auf der siliziumhaltigen Oberfläche eine Monolage von hydrophoben Molekülketten, die die Adsorption von Wassermolekülen unterbindet. Hierfür eignen sich prinzipiell sämtliche hydrophoben Molekülketten, die eine stabile Verbindung mit der Oberfläche eingehen. Somit kann für bestimmte Substrate eine Lösung der beschriebenen Probleme erreicht werden. Nachteilig ist, dass bestimmte gängige hydrophobe Molekülketten auf Aluminium oder aluminiumhaltigen Substanzen nicht haften.

Der Erfindung liegt die Aufgabe zugrunde, einen Sensor, der Bestandteile aus Aluminium aufweist, die oberflächlich positioniert sind, derart zu gestalten, dass in Verbindung mit Luftfeuchtigkeit aus der Umgebung keine Störsignale auftreten. Weiterhin ist ein Verfahren zu dessen Herstellung anzugeben.

Die Lösung dieser Aufgabe wird durch die jeweilige Merkmalskombination des Anspruchs 1 bzw. des Anspruches 6 ermöglicht.
Vorteilhafte Ausgestaltungen sind den Unteransprüchen zu entnehmen.

Der Erfindung liegt die Erkenntnis zugrunde, dass, nachdem der Stoff n-Octadecyltrichlorosilan nicht direkt auf Aluminium haftet, eine Vorbehandlung dieser Oberflächen notwendig ist. Die Vorbehandlung geschieht in einfacher Weise durch ein Tauchbad in Kieselsäure, wobei erfindungsgemäß eine selbst organisierende Monolage aus Aluminiumsilikat entsteht. Diese Monolage Aluminiumsilikat stellt bereits eine Schutzschicht dar, die einen geringfügigen Schutz bietet. Wesentlich ist jedoch die stabile chemische Verbindung, die n-Octadecyltrichlorosilan mit der Aluminiumsilikatschicht bildet. Da dies eine sehr stabile Verbindung ist, liefert sie insgesamt den eigentlichen und hochwirksamen Schutz gegen Feuchtigkeit und Korrosion. Dabei dient die Silikatschicht der Haftvermittlung und die Schicht aus n-Octadecyltrichlorosilan gewährleistet einen sehr wirksamen Korrosionsschutz. Somit liegen zwei übereinander aufgebrachte Schutzschichten vor, von denen mindestens eine als eine selbst organisierende Monolage dargestellt ist. Der wesentliche Schutz wird durch die zweite und damit oberste Schicht erreicht. Es lassen sich wesentliche Säurebeständigkeiten realisieren. Die hydrophobe Wirkung ist weitreichend, so dass sich keinerlei Feuchtefilme im normalen Betrieb ausbilden, wodurch insbesondere die Korrosion durch in der Niederschlagsfeuchtigkeit vorhandene Säuren verhindert wird.

Sowohl die Behandlung zur Ausbildung einer Aluminiumsilikatschicht als auch zur Ausbildung einer n-Octadecyltriehlorosilanschicht geschieht durch ein entsprechendes Tauchbad.

Die Metallisierung des Sensors in Form von Aluminium kann somit wirksam gegen Feuchtigkeit und Säuren geschützt werden.

Der Schutz ist im wesentlichen durch Vermessung von Wasser auf den entsprechend behandelten Oberflächen nachweisbar. Der Kontaktwinkel von Wassertropfen beträgt beispielsweise -9°, was gleichbedeutend ist mit der Tendenz, dass ein auf einer Oberfläche aufsitzender Wassertropfen an seiner Kontaktfläche zur Oberfläche nach innen gewölbt ist, also die gegenteilige Erscheinung wie eine benetzende, das heißt nach außen verlaufende Form, wie sie bei hydrophilen Substanzen vorliegt, zeigt.

Eine weitere Darstellung der wirksamen Passivierung der entsprechenden Metalloberflächen lässt sich durch jeweiliges Aufbringen eines Wassertropfens auf einer unbehandelten . Aluminium- oder einer passivierten Aluminiumoberfläche darstellen. Verläuft der Wassertropfen auf einer Aluminiumoberfläche zu einer flachen Wasserzone, so bildet der Wassertropfen auf einer passivierten Oberfläche eine Perle oder einen Teil einer Kugel, wie eine Halbkugel, so dass die Flüssigkeitsoberfläche insgesamt die Form mit dem kleinstmöglichen Energieinhalt einnimmt.

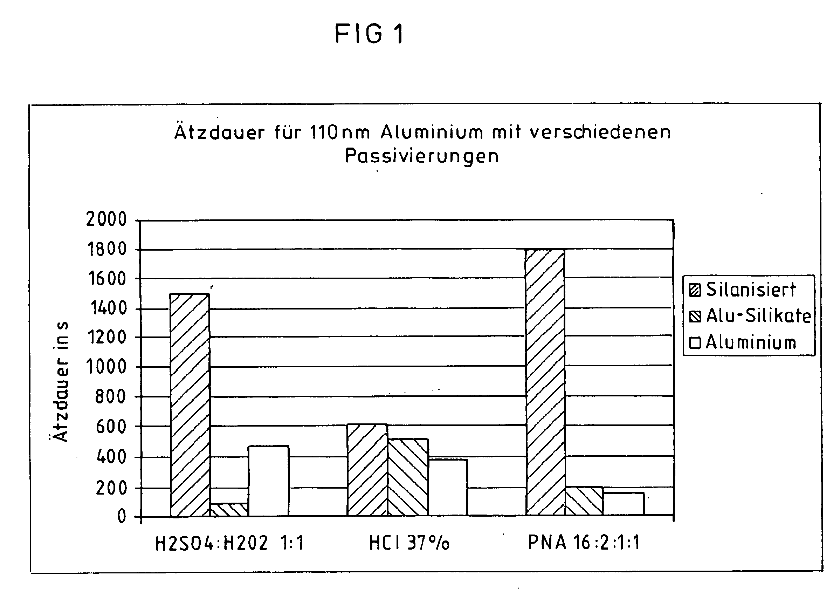

Anhand der beigefügten Figur lässt sich der Korrosionsschutz der aufgrund der hydrophoben Oberflächenbehandlung mit der Erfindung erzielbar ist, nachweisen. In dem Diagramm entsprechend der Figur ist auf der Ordinate die Ätzdauer in Sekunden angetragen. Auf der Abszisse sind drei Gruppen entsprechend dreier Ätzmethoden dargestellt, wobei in den jeweiligen drei Balken von rechts beginnend ein Aluminiumbauteil ohne Schutzschicht, ein Aluminiumsilikatbauteil mit Silikatschicht/Haftvermittler und ein silanisiertes, also insgesamt mit zwei Schichten entsprechend der Erfindung passiviertes Bauteil, behandelt werden. Die jeweiligen drei Gruppen bedeuten von links beginnend eine Ätzung mit einem Gemisch aus Schwefelsäure und Wasserstoffperoxid im Verhältnis 1:1, einer Ätzung mit Salzsäure 37%ig, und eine Ätzung mit Phosphornitrogensäure im entsprechenden Verhältnis. Beginnend mit dem rechten Balken der jeweiligen Gruppe ergibt sich eine Zeit zwischen etwa 150 und 450 Sekunden für die Ätzdauer einer Schicht aus 110 nm Aluminium. Die Werte in Verbindung mit dem mittleren Balken einer jeden Gruppe bedeuten die Zeit, in der ein mit Aluminiumsilikat passiviertes Metall mit gleichem Betrag geätzt wird. Der herausragende Vorteil der Erfindung zeigt sich im jeweils linken Balken einer Gruppe, wobei zu erkennen ist, dass eine nach der Erfindung passivierte Aluminiumoberfläche mindestens 600 Sekunden bei einer Salzsäureätzung standhält und bei der linken und rechten Gruppe jeweils mindestens 1500 oder 1800 Sekunden für gleiche Auswirkungen zu ätzen ist.

## Patentansprüche

1. Sensor mit einem elektrische Signale ausgebenden Detektionselement , der oberflächliche Bauteile aus Aluminium aufweist, wobei auf der Oberfläche dieser Bauteile eine erste Schicht aus Silikaten vorhanden ist und darauf eine zweite Schicht, bestehend aus einem Trichlorsilan, aufgebracht ist, **dadurch gekennzeichnet, dass** die Silikatschicht aus Aluminiumsilikat besteht.

2. Sensor nach Anspruch 1, bei dem das Trichlorsilan ein n-Octadecyltrichlorosilan ist.

3. Sensor nach einem der Ansprüche 1 oder 2 , bei dem mindestens eine der ersten oder zweiten Schicht durch eine Monolage von Molekülen dargestellt ist.

4. Sensor nach einem der Ansprüche 1 bis 3, bei dem die Bauteile an Gassensoren, Drucksensoren oder Beschleunigungssensoren zur Passivierung mit der ersten und der zweiten Schicht versehen sind.

5. Sensor nach einem der vorhergehenden Ansprüche, bei dem ein Gassensor zur Signalauslesung mit einer Feldeffekttransistorstruktur versehen ist.

6. Verfahren zur Herstellung eines Sensors entsprechend einem der Ansprüche 1 bis 6, bei dem eine haftvermittelnde Zwischenlage durch eine erste Schicht dargestellt wird, indem der Sensor in einem Tauchbad mit Kieselsäure (H4SiC>4) behandelt wird, um eine Schicht aus Aluminiumsilikat auszubilden und bei dem eine zweite Schicht auf der ersten Schicht hergestellt wird, indem der Sensor in einem Tauchbad mit n-Octadecyltrichlorosilan behandelt wird.

7. Verfahren nach Anspruch 6, bei dem bei einer Tauchbadbehandlung zur Herstellung einer ersten oder zweiten Schicht eine monolagige Schicht ausgebildet wird.

## Claims

1. A sensor with a detection element which emits electrical signals and which has surface components of aluminium, wherein a first coating of silicates is present on the surface of these components and a second coating consisting of a trichlorosilane is applied thereto, **characterized in that** the silicate coating consists of aluminium silicate.

2. A sensor according to claim 1, in which the trichlorosilane is an n-octadecyltrichlorosilane.

3. A sensor according to one of claims 1 or 2, in which at least one of the first coating or the second coating is formed by a mono-layer of molecules.

4. A sensor according to any one of claims 1 to 3, in which the components on gas sensors, pressure sensors or acceleration sensors for passivation are provided with the first and the second coating.

5. A sensor according to any one of the preceding claims, in which a gas sensor for reading out signals is provided with a field effect transistor structure.

6. A method of producing a sensor in accordance with any one of claims 1 to 6 [sic], in which an adhesion-promoting intermediate layer is formed by a first coating, by the sensor being treated in an immersion bath with silicic acid (H4SiC>4) [sic] in order to form a coating of aluminium silicate, and in which a second coating is produced on the first coating, by the sensor being treated in an immersion bath with n-octadecyltrichlorosilane.

7. A method according to claim 6, in which a monolayer coating is applied during an immersion bath treatment in order to form a first or second coating.

## Revendications

1. Capteur comportant un élément de détection générant des signaux électriques et ayant des composants de surface en aluminium,
- la surface des composants ayant une première couche de silicates et sur celle-ci une seconde couche de trichlorosilane,
capteur **caractérisé en ce que**
la couche de silicates est du silicate d'aluminium.

2. Capteur selon la revendication 1,
**caractérisé en ce que**
le trichlorosilane est le n-octadécyltrichlorosilane.

3. Capteur selon l'une des revendications 1 ou 2,
**caractérisé en ce qu'**
au moins la première ou la seconde couche est une couche monomoléculaire.

4. Capteur selon l'une des revendications 1 à 3,
**caractérisé en ce que**
les composants pour des capteurs de gaz, des capteurs de pression ou des capteurs d'accélération, sont munis d'une première et d'une seconde couche pour la passivation.

5. Capteur selon l'une des revendications précédentes,
**caractérisé en ce que**
le capteur de gaz a une structure de transistor à effet de champ pour fournir les signaux.

6. Procédé de fabrication d'un capteur selon l'une des revendications 1 à 5,
procédé **caractérisé en ce qu'**
on réalise une couche intermédiaire d'accrochage constituée par une première couche, en traitant le capteur dans un bain d'immersion avec de l'acide silicique (H₄SiO₄) pour former une couche de silicate d'aluminium et on réalise une seconde couche sur la première couche en traitant le capteur dans un bain d'immersion avec du n-octadécyltrichlorosilane.

7. Procédé selon la revendication 6,
**caractérisé en ce que**
le traitement par le bain d'immersion réalise une première ou une seconde couche monomoléculaire.
